(19) Europäisches Patentamt
European Patent Office
Office européen des brevets

(11) Veröffentlichungsnummer: **0 056 092**
**B1**

# (12) EUROPÄISCHE PATENTSCHRIFT

(45) Veröffentlichungstag der Patentschrift: **08.08.84**

(21) Anmeldenummer: **81109001.8**

(22) Anmeldetag: **27.10.81**

(51) Int. Cl.³: **G 03 C 1/56,** G 03 C 1/60, G 03 C 1/94 // G03F7/08, G03F7/26

## (54) Lichtempfindliches Gemisch auf Basis von o-Naphthochinondiaziden und daraus hergestelltes lichtempfindliches Kopiermaterial.

(30) Priorität: **14.01.81 DE 3100856**

(43) Veröffentlichungstag der Anmeldung: **21.07.82 Patentblatt 82/29**

(45) Bekanntmachung des Hinweises auf die Patenterteilung: **08.08.84 Patentblatt 84/32**

(84) Benannte Vertragsstaaten: **AT BE CH DE FR GB IT LI NL SE**

(56) Entgegenhaltungen: **Keine**

(73) Patentinhaber: **HOECHST AKTIENGESELLSCHAFT, Postfach 80 03 20, D-6230 Frankfurt am Main 80 (DE)**

(72) Erfinder: **Stahlhofen, Paul, Dr., Leibnizstrasse 18/B, D-6200 Wiesbaden (DE)**

**EP 0 056 092 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein positiv arbeitendes lichtempfindliches Gemisch, das als lichtempfindliche Verbindung einen Naphthochinon-(1,2)-diazid-(2)-sulfonsäureester eines mehrwertigen, Ketogruppen enthaltenden Phenols enthält und das insbesondere zur Herstellung von Flachdruckplatten bestimmt ist.

Lichtempfindliche Verbindungen der angegebenen Gattung sind aus der DE-PS 938 233 und der US-PS 3 802 885 bekannt. Es handelt sich hierbei um teilweise oder vollständig mit Naphthochinondiazidsulfonsäuren veresterte Di- oder Trihydroxybenzophenone. Von diesen Verbindungen werden in neuerer Zeit die vollständig veresterten Vertreter bevorzugt, die keine freien phenolischen OH-Gruppen mehr enthalten. Diese Verbindungen weisen eine relativ hohe Lichtempfindlichkeit auf und ergeben hohe Druckauflagen, sie haben jedoch den Nachteil einer für manche Zwecke zu geringen Löslichkeit in den üblicherweise zur Beschichtung von Druckplatten verwendeten organischen Lösungsmitteln, wie Glykolpartialethern oder Carbonsäurealkylestern wie Butylacetat. Sie ergeben ferner in Kombination mit den bevorzugten, wasserunlöslichen, in wäßrig-alkalischen Lösungsmitteln löslichen Bindemitteln, z. B. Novolaken, Schichten, die in unbelichtetem Zustand gegenüber den gebräuchlichen alkalischen Entwicklerlösungen nicht genügend resistent sind. Diese Schichten werden auch während des Drucks in Offsetdruckmaschinen bei Verwendung von Alkohol enthaltenden Feuchtwässern in gewissem Maße angegriffen.

Aus der DE-OS 2 828 037 sind Gemische bekannt, die Naphthochinondiazidsulfonsäureester von bestimmten Bisphenolderivaten enthalten, in denen zwei Benzolringe über eine aliphatisch substituierte Methylenbrücke verbunden sind. Diese Verbindungen haben eine hohe Löslichkeit in organischen Lösungsmitteln. Ihre Resistenz gegenüber alkalischen Entwicklerlösungen und Alkohol enthaltenden Feuchtwässern ist jedoch noch nicht optimal.

Aufgabe der Erfindung war es, ein lichtempfindliches, positiv arbeitendes Gemisch mit einem neuen Naphthochinon-(1,2)-diazid-(2)-sulfonsäureester als lichtempfindliche Verbindung vorzuschlagen, das in seinen druck- und kopiertechnischen Eigenschaften mit den besten bisher bekannten Gemischen dieser Art mindestens vergleichbar ist, das aber eine höhere Resistenz gegenüber wäßrigalkalischen Entwicklerlösungen und den beim Offsetdruck verwendeten Alkohol enthaltenden Feuchtwässern, eine harte Gradation, eine hohe Löslichkeit in organischen Lösungsmitteln und gute Oleophile aufweist und sich in einfacher Weise in chemisch einheitlicher Form herstellen läßt.

Gegenstand der Erfindung ist ein lichtempfindliches Gemisch, das als lichtempfindliche Verbindung einen Naphthochinon-(1,2)-diazid-(2)-4- oder -5-sulfonsäureester eines mehrwertigen, Ketogruppen enthaltenden Phenols enthält.

Das erfindungsgemäße Gemisch ist dadurch gekennzeichnet, daß der Naphthochinondiazidsulfonsäureester der allgemeinen Formel I

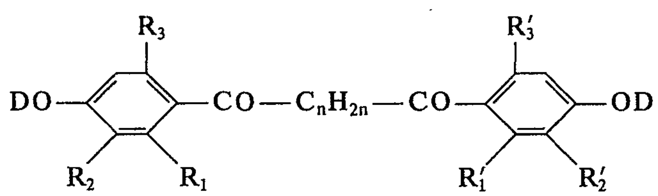

(I)

entspricht, worin

- D der Naphtochinon-(1,2)-diazid-(2)-5-sulfonyl- oder -4-sulfonyl-, bevorzugt der -5-sulfonylrest ist,
- $R_1$, $R_2$, $R_3$, $R_1'$, $R_2'$ und $R_3'$ Wasserstoff- oder Halogenatome, Alkylgruppen mit 1—4 Kohlenstoffatomen oder Reste der Formel DO sind und
- n eine Zahl von 2 bis 18, bevorzugt von 6 bis 14,

bedeutet, wobei insgesamt nicht mehr als drei DO-Reste an einem Benzolring stehen.

Erfindungsgemäß wird ferner ein lichtempfindliches Kopiermaterial aus einem Schichtträger und einer lichtempfindliche Schicht vorgeschlagen, die einen Naphthochinon-(1,2)-diazid-(2)-sulfonsäureester eines mehrwertigen, Ketogruppen enthaltenden Phenols enthält, das dadurch gekennzeichnet ist, daß der Naphthochinondiazidsulfonsäureester der oben definierten Formel I entspricht.

Von den Verbindungen der Formel I werden diejenigen bevorzugt, in denen in jedem Benzolring mindestens zwei DO-Gruppen stehen. Besonders bevorzugte werden die vom Resorcin abgeleiteten Derivate, d. h. die Verbindungen, in denen $R_1$ und $R_1'$ DO-Reste und $R_2$, $R_3$, $R_2'$ und $R_3'$ Wasserstoffatome sind.

Als Alkylsubstituenten werden Methyl- und Ethyl-, insbesondere Methylgruppen bevorzugt. Als Halogenatome kommen bevorzugt Chlor- oder Bromatome in Betracht.

Die in dem erfindungsgemäßen Gemisch enthaltenen Chinondiazide sind neu. Ihre Herstellung erfolgt in Analogie zu bekannten Verfahren durch Veresterung der phenolischen OH-Gruppen mit o-Chinondiazidsulfonsäuren oder deren reaktionsfähigen Derivaten, z. B. den Sulfonsäurechloriden.

Die entsprechenden Vorprodukte, die Diketophenole, erhält man z. B. durch Umsetzung der entsprechenden Phenole mit Dicarbonsäuren in der Schmelze bei ca 140° C in Gegenwart von wasserfreiem Zinkchlorid. Die Reaktionszeit beträgt hierbei 2 bis 5 Stunden. Einige der in Tabelle 1 aufgeführten durch Umsetzung von höheren Paraffindicarbonsäuren mit Resorcin hergestellten Diketophenole wurden bereits von J. v. Braun, Anton und Meyer in Chem. Ber. 74 (1941), 1772 beschrieben.

Die Ausbeute an Diketophenol kann gegebenenfalls wesentlich gesteigert werden, wenn die Phenolkomponente im Überschuß (bis zum Fünffachen der stöchiometrischen Menge) eingesetzt wird. Anstelle von Zinkchlorid läßt sich diese Umsetzung auch vorteilhaft Bortrifluorid verwenden. Zu diesem Zweck wird die Reaktionsschmelze bei 80 bis 120° C 2 bis 3 Stunden mit Bortrifluorid gesättigt. Zur Aufarbeitung wird das noch flüssige Reaktionsgemisch unter gutem Rühren in Eiswasser gegossen. Das ausgefallene Reaktionsprodukt wird gegebenenfalls mit n/10-Sodalösung oder Ammoniaklösung behandelt. Hierbei gehen eventuell entstandene Ketosäure und nicht umgesetzte Dicarbonsäure in Lösung während die Diketoverbindung zurückbleibt.

Einige der aus den entsprechenden Phenolen und Dicarbonsäuren hergestellten Diketophenole sind in der folgenden Tabelle aufgeführt. Die Diketophenole sind farblos bis gelb gefärbt. In Spalte 3 sind die Schmelzpunkte angegeben, die nach Umkristallisieren aus den in Klammern angegebenen Lösungsmitteln erhalten wurden.

Tabelle 1

| Phenolkomponente | Dicarbonsäure | Diketophenol Schmp. (0° C) |
|---|---|---|
| Resorcin | Bernsteinsäure | 305 (Pyridin) |
| Resorcin | Adipinsäure | 285 (Methanol) |
| Resorcin | Korksäure | 187 (Wasser/Aceton) |
| Phenol | Sebacinsäure | 195 (Ethanol) |
| Resorcin | Sebacinsäure | 167 (Wasser/Ethanol) |
| Pyrogallol | Sebacinsäure | 184 (Ethanol) |
| Resorcin | 1,10-Decandicarbonsäure | 152 (Toluol) |
| Resorcin | 1,12-Dodecandicarbonsäure | 162 (Toluol) |
| Resorcin | 1,14-Tetradecandicarbonsäure | 161 (Eisessig) |
| Resorcin | 1,16-Hexandecandicarbonsäure | 139 (Eisessig) |
| Resorcin | 1,11-Undecandicarbonsäure | 146 (Eisessig) |
| Pyrogallol | Bernsteinsäure | $>300$ (Ethanol) |
| Phenol | Bernsteinsäure | 191 (Eisessig) |
| m-Kresol | Adipinsäure | 123 (Ethanol) |
| Resorcin | Azelainsäure | 142 (Ethanol) |
| Phloroglucin | Sebacinsäure | 270 (Eisessig) |

Die Konzentration der neuen Naphthochinondiazidsulfonsäureester in der lichtempfindlichen Schicht kann in relativ weiten Grenzen schwanken. Im allgemeinen liegt der Anteil bei 3 bis 50, vorzugsweise zwischen 7 und 25 Gew.-%, bezogen auf den Gehalt an nicht-flüchtigen Bestandteilen des lichtempfindlichen Gemischs.

Die erfindungsgemäßen lichtempfindlichen Gemische enthalten bevorzugt ferner ein polymeres, wasserunlösliches harzartiges Bindemittel, das sich in den für das erfindungsgemäße Gemisch verwendeten Lösungsmitteln löst und in wäßrigen Alkalien ebenfalls löslich oder zumindest quellbar ist.

Die bei vielen Positiv-Kopiermaterialien auf Basis von Naphthochinondiazide bewährten Novolak-Kondensationsharze haben sich als Zusatz auch bei den erfindungsgemäßen Gemischen mit den neuen Naphthochinondiazidsulfonsäureestern als besonders brauchbar und vorteilhaft erwiesen. Sie fördern die starke Diferenzierung zwischen den belichteten und unbelichteten Schichtpartien beim Entwickeln, besonders die höher kondensierten Harze mit substituierten Phenolen, z. B. Kresolen, als Formaldehyd-Kondensationspartner. Als weitere alkalilösliche bzw. in Alkali quellbare Bindemittel sind natürliche Harze, wie Schellack und Kolophonium, und synthetische Harze, wie Mischpolymerisate aus Styrol und Maleinsäureanhydrid oder Mischpolymerisate der Acrylsäure oder Methacrylsäure, insbesondere mit Acryl- oder Methacrylsäureestern, zu nennen.

Die Art und Menge des alkalilöslichen Harzes kann je nach Anwendungszweck verschieden sein; bevorzugt werden Anteile am Gesamtfeststoff zwischen 95 und 50, besonders bevorzugt 90—65 Gew.-%. Zusätzlich können noch zahlreiche andere Harze mitverwendet werden, bevorzugt Epoxide und Vinylpolymerisate wie Polyvinylacetate, Polyacrylate, Polyvinylacetale, Polyvinylether, Polyvinylpyrrolidone und die Mischpolymerisate der ihnen zugrundeliegenden Monomeren. Der günstigste Anteil an diesen Harzen richtet sich nach den anwendungstechnischen Erfordernissen und dem Einfluß auf die Entwicklungsbedingungen und beträgt im allgemeinen nicht mehr als 20 Gew.-% vom alkalilöslichen Harz. In geringen Mengen kann das lichtempfindliche Gemisch für spezielle Erfordernisse wie Flexibilität, Haftung, Glanz, Färbung und Farbumschlag etc. außerdem noch Substanzen wie Polyglykole, Cellulosederivate wie Ethylcellulose, Netzmittel, Farbstoffe, Haftvermittler und feinteilige Pigmente sowie bei Bedarf UV-Absorber enthalten.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemische Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether, werden besonders bevorzugt.

Als Schichtträger für Schichtdicken unter ca. 10 µm werden meist Metalle verwendet. Für Offsetdruckplatten können eingesetzt werden: walzblankes, mechanisch oder elektrochemisch aufgerauhtes und gegebenenfalls anodisiertes Aluminium, das zudem noch chemisch, z. B. mit Polyvinylphosphonsäure, Silikaten, Phosphaten, Hexafluorozirkonate oder mit hydrolysiertem Tetraethylorthosilikat, vorbehandelt sein kann, außerdem Mehrmetallplatten z. B. aus Al/Cu/Cr oder aus Messing/Chrom. Für die Herstellung von Hochdruckplatten können die erfindungsgemäßen Gemische auf Zink- oder Magnesium-Platten sowie deren handelsübliche mikrokristalline Legierungen für Einstufenätzverfahren aufgetragen werden, außerdem auf ätzbare Kunststoffe wie Polyoxymethylen. Für Tiefdruck- oder Siebdruckformen eignen sich die erfindungsgemäßen Gemische durch ihre gute Haftung und Ätzfestigkeit auf Kupfer- und Nickeloberflächen. Ebenso lassen sich die erfindungsgemäßen Gemische als Photoresists in der Leiterplattenfertigung und beim Formteilätzen verwenden. Für weitere Anwendungen kommen auch andere Träger wie Holz, Papier, Keramik, Textil und andere Metalle in Betracht.

Bevorzugte Träger für dicke Schichten über 10 µm sind Kunststoff-Folien, die dann als temporäre Träger für Transferschichten dienen. Dafür und für Farbprüffolien werden Polyesterfolien, z. B. aus Polyethylenterephthalat, bevorzugt. Polyolefinfolien wie Polypropylen sind jedoch ebenfalls geeignet.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag. Schließlich kann die Beschichtung von z. B. Leiterplatten, Glas oder Keramik und Silizium-Scheiben auch durch Schichtübertragung von einem temporären Träger erfolgen. Belichtet wird mit den in der Technik üblichen Lichtquellen. Auch das Bestrahlen mit Elektronen oder Lasern stellt eine Möglichkeit zur Bebilderung dar.

Die zum Entwickeln verwendeten wäßrig-alkalischen Lösungen abgestufter Alkalität, vorzugsweise mit einem pH im Bereich von 10—14, die auch kleinere Mengen organischer Lösungs- oder Netzmittel enthalten können, entfernen die vom Licht getroffenen Stellen der Kopierschicht und erzeugen so ein positives Abbild der Vorlage.

Bevorzugte Anwendung finden die erfindungsgemäßen lichtempfindlichen Gemische bei der Herstellung von Druckformen, d. h. insbesondere Offset-, autotypischen Tiefdruck- und Siebdruckformen, in Kopierlacken und sogenannten Trockenresists.

Die unter Verwendung der neuen Verbindungen hergestellten Druckplatten besitzen eine hohe praktische Lichtempfindlichkeit, sowie eine verbesserte Resistenz gegenüber alkalischen Entwicklern. Die bevorzugten Verbindungen selbst zeichnen sich durch eine sehr gute Löslichkeit in den üblichen Lösungsmitteln, durch eine starke Oleophilie und Alkoholresistenz sowie durch eine gute Verträglichkeit mit den übrigen Bestandteilen der Kopierschicht aus.

Die Erfindung wird an Hand der folgenden Beispiele näher erläutert, in denen Gewichtsteile (Gt) und

Volumteile (Vt) im Verhältnis von g zu $cm^3$ stehen. Prozente sind, wenn nichts anderes angegeben ist, Gewichtsprozente.

Beispiel 1

Mit einer Lösung von

1,10 Gt des Veresterungsproduktes aus 1 Mol 1,10-Bis-(2,4-dihydroxy-phenyl)-decandion-(1,10) und 4 Mol Naphthochinon-(1,2)-diazid-(2)-5-sulfonsäurechlorid
5,70 Gt eines Kresol-Formaldehyd-Novolaks mit einem Erweichungspunkt von 105—120°C nach DIN 53 181,
0,12 Gt 4-(p-Tolylmercapto)-2,5-diethoxy-benzoldiazoniumhexafluorophosphat,
0,40 Gt 2,3,4-Trihydroxy-benzophenon und
0,06 Gt Kristallviolett in
40 Gt Ethylenglykolmonomethylether und
50 Gt Tetrahydrofuran

wurde eine elektrolytisch aufgerauhte und anodisierte Aluminiumplatte mit einem Oxidgewicht von 3,0 $g/m^2$ beschichtet. Der anodisierte Aluminium-Träger war vor dem Aufbringen der lichtempfindlichen Kopierschicht mit einer wäßrigen Lösung von Polyvinylphosphonsäure behandelt worden, wie es in der DE-PS 1 621 478 beschrieben ist.

Das so hergestellte vorsensibilisierte Material mit einem Schichtgewicht der lichtempfindlichen Schicht von 2,30 $g/m^2$ wurde unter einer transparenten Positiv-Vorlage bildmäßig belichtet und anschließend mit der folgenden Lösung entwickelt:

5,3 Gt Natriummetasilikat × 9 Wasser
3,4 Gt Trinatriumphosphat × 12 Wasser
0,3 Gt Natriumdihydrogenphosphat (wasserfrei) in
91,0 Gt Wasser.

Durch die Entwicklung wurden die von Licht getroffenen Anteile der Kopierschicht entfernt, und es blieben die unbelichteten Bildstellen auf dem Schichtträger zurück. Von der so hergestellten Druckform wurden in einer Offsetmaschine etwa 200 000 einwandfreie Drucke hergestellt. Die Druckschablone zeichnete sich durch eine ausgezeichnete Oleophilie, Alkoholresistenz und Haftung auf dem Träger aus.

Während die Löslichkeit des oben angegebenen Naphthochinondiazidsulfonsäureesters in Ethylenglykolmonomethylether bei 23°C 42 Gew.-% beträgt, ließ sich von dem Veresterungsprodukt aus 1 Mol 2,4-Dihydroxy-acetophenon und 2 Mol Naphthochinon-(1,2)-diazid-(2)-5-sulfonsäurechlorid unter gleichen Versuchsbedingungen maximal nur eine 0,4%ige Lösung in Ethylenglykolmonomethylether herstellen.

In den folgenden Beispielen werden weitere Beschichtungslösungen angegeben, mit denen ähnliche Ergebnisse erhalten wurden. Wenn nicht gesondert vermerkt, entsprechen Herstellung und Verarbeitung der damit erhaltenen Druckplatten den in Beispiel 1 beschriebenen Bedingungen.

Beispiel 2

Mit einer Lösung von

1,10 Gt des Veresterungsproduktes aus 1 Mol 1,14-Bis-(2,4-dihydroxy-phenyl)-tetradecandion-(1,14) und 4 Mol Naphthochinon-(1,2)-diazid-(2)-5-sulfonsäurechlorid,
6,10 Gt des in Beispiel 1 angegebenen Novolaks
0,14 Gt Naphthochinon-(1,2)-diazid-(2)-4-sulfonsäurechlorid, und
0,06 Gt Kristallviolett in
30 Gt Ethylenglykolmonomethylether,
40 Gt Tetrahydrofuran,
10 Gt Butylacetat

wurde eine elektrolytisch aufgerauhte und anodisierte Aluminiumplatte beschichtet.

Beispiel 3

Mit einer Lösung von

1,30 Gt des Veresterungsproduktes aus 1 Mol 1,8-Bis-(2,4-dihydroxy-phenyl)-octandion-(1,8) und 4 Mol Naphthochinon-(1,2)-diazid-(2)-5-sulfonsäurechlorid,
5,80 Gt des in Beispiel 1 angegebenen Novolaks,
0,18 Gt Naphthochinon-(1,2)-diazid-(2)-4-sulfonsäurechlorid und
0,07 Gt Kristallviolett in
30 Gt Ethylenglykolmonomethylether,
40 Gt Tetrahydrofuran
10 Gt Butylacetat

wurde eine elektrolytisch aufgerauhte und anodisierte Aluminiumplatte beschichtet, die mit einer wäßrigen Lösung von Polyvinylphosphonsäure nachbehandelt worden war.

Beispiel 4

Mit einer Lösung von

1,10 Gt des Veresterungsproduktes aus 1 Mol 1,10-Bis-(2,3,4-trihydroxy-phenyl)-decandion-(1,10) und 6 Mol Naphthochinon-(1,2)-diazid-(2)-5-sulfonsäurechlorid,
5,70 Gt des in Beispiel 1 angegebenen Novolaks,
0,12 Gt 4-(p-Tolylmercapto)-2,5-diethoxy-benzoldiazoniumhexafluorophosphat,
0,40 Gt 2,3,4-Trihydroxy-benzophenon und
0,06 Gt Kristallviolett in
40 Gt Ethylenglykolmonomethylether und
50 Gt Tetrahydrofuran

wurde eine elektrolytisch aufgerauhte und anodisierte Aluminiumplatte beschichtet, die mit einer wäßrigen Lösung von Polyvinylphosphonsäure nachbehandelt worden war.

Beispiel 5

Mit einer Lösung von

1,00 Gt des Veresterungsproduktes aus 1 Mol 1,12-Bis-(2,4-dihydroxy-phenyl)-dodecandion-(1,12) und 4 Mol Naphthochinon-(1,2)-diazid-(2)-5-sulfonsäurechlorid,
6,40 Gt des in Beispiel 1 angegebenen Novolaks,
0,20 Gt eines Polyvinylacetals mit ca. 70% Vinylacetal-, 24—27% Vinylalkohol- und 1% Vinylacetat-einheiten,
0,12 Gt Naphthochinon-(1,2)-diazid-(2)-4-sulfonsäurechlorid, und
0,06 Gt Kristallviolett in
30 Gt Ethylenglykolmonomethylether,
40 Gt Tetrahydrofuran und
10 Gt Butylacetat

wurde eine durch Stahldrahtbürsten mechanisch aufgerauhte Aluminiumfolie beschichtet.

Beispiel 6

Mit einer Lösung von

1,20 Gt des Veresterungsproduktes aus 1 Mol 1,10-Bis-(2,4-dihydroxy-phenyl)-decandion-(1,10) und 4 Mol Naphthochinon-(1,2)-diazid-(2)-4-sulfonsäurechlorid,
6,30 Gt des in Beispiel 1 angegebenen Novolaks,
0,12 Gt 4-(p-Tolylmercapto)-2,5-diethoxy-benzoldiazoniumhexafluorophosphat und
0,06 Gt Kristallviolett in
40 Gt Ethylenglykolmonomethylether und
50 Gt Tetrahydrofuran

wurde eine elektrolytisch aufgerauhte und anodisierte Aluminiumplatte mit einem Oxidgewicht von 3,0 $g/m^2$ beschichtet.

Beispiel 7

Mit einer Lösung von

1,20 Gt des Veresterungsproduktes aus 1 Mol 1,10-Bis-(4-hydroxy-phenyl)-decandion-(1,10) und 2 Mol Naphthochinon-(1,2)-diazid-(2)-5-sulfonsäurechlorid,
6,00 Gt des in Beispiel 1 angegebenen Novolaks,
0,10 Gt Naphthochinon-(1,2)-diazid-(2)-4-sulfonsäurechlorid,
0,20 Gt 2,3,4-Trihydroxy-benzophenon und
0,06 Gt Kristallviolett in
35 Gt Ethylenglykolmonomethylether,
45 Gt Tetrahydrofuran und
10 Gt Butylacetat

wurde eine elektrolytisch aufgerauhte und anodisierte Aluminiumplatte mit einem Oxidgewicht von 2,0 g/$m^2$ beschichtet.

Beispiel 8

Mit einer Lösung von

1,00 Gt des Veresterungsproduktes aus 1 Mol 1,4-Bis-(2,4-dihydroxy-phenyl)-butandion-(1,4) und 4 Mol Naphthochinon-(1,2)-diazid-(2)-5-sulfonsäurechlorid.
6,30 Gt des in Beispiel 1 angegebenen Novolaks,
0,11 Gt 4-(p-Tolylmercapto)-2,5-diethoxy-benzoldiazoniumhexafluorophosphat und
0,06 Gt Kristallviolett in
40 Gt Ethylenglykolmonomethyleter und
50 Gt Tetrahydrofuran

wurde eine elektrolytisch aufgerauhte und anodisierte Aluminiumplatte beschichtet, die mit einer wäßrigen Lösung von Polyvinylphosphonsäure nachbehandelt worden war.

Beispiel 9

Dieses Beispiel beschreibt eine Kopierschichtlösung, die als Positiv-Kopierlack für verschiedene Zwecke, insbesondere für das Herstellen von Ätzschablonen, verwendet werden kann, z. B. beim Ätzen von Formteilen und Schildern und bei der Herstellung von Leiterbildern, insbesondere auch für die Mikroelektronik. Die Lösung wies eine gute Haltbarkeit auf. Die Beschichtungsart und die Schichtdicke konnten in weiten Grenzen den jeweiligen Anforderungen angepaßt werden. Nach der Belichtung hoben sich die belichteten Gebiete von den unbelichteten Gebieten kontrastreich ab. Die belichteten Gebiete ließen sich mit einem alkalischen Entwickler (pH etwa 12,8) mühelos entfernen.

Mit einer Lösung von

1,5 Gt des Veresterungsproduktes aus 1 Mol 1,10-Bis-(2,4-dihydroxy-phenyl)-decandion-(1,10) und 4 Mol Naphthochinon-(1,2)-diazid-(2)-5-sulfonsäurechlorid,
0,4 Gt 4-(p-Tolylmercapto)-2,5-diethoxy-benzoldiazoniumhexafluorophosphat,
0,1 Gt Kristallviolett (C. I. 42 555),
10,0 Gt des in Beispiel 1 angegebenen Novolaks und
2,0 Gt Epoxyharz mit einem Epoxyäquivalentgewicht von 450—500 und einem Schmelzbereich von 64—74° C in
40 Vt Ethylenglykolmonomethylether,
50 Vt Tetrahydrofuran und
10 Vt Butylacetat

Mit dieser Lösung wird eine mit einer 35 µm starken Kupfer-Folie kaschierte Isolierstoffplatte beschichtet.

Beispiel 10

Mit einer Lösung von

1,20 Gt des Veresterungsproduktes aus 1 Mol 1,10-Bis-(2,4-dihydroxy-phenyl)-decandion-(1,10) und 4 Mol Naphthochinon-(1,2)-diazid-(2)-5-sulfonsäurechlorid

5,60 Gt des in Beispiel 1 angegebenen Novolaks,
0,12 Gt 4-(p-Tolylmercapto)-2,5-diethoxy-benzoldiazoniumhexafluorophosphat,
0,20 Gt 2,3,4-Trihydroxy-benzophenon und
1,00 Gt Kristallviolett in
40 Gt Ethylenglykolmonomethylether,
40 Gt Tetrahydrofuran und
10 Gt Butylacetat

wurde eine biaxial verstreckte und thermofixierte Polyethylenterephthalatfolie beschichtet. Die erhaltene Farbfolie wurde zur Herstellung von Anhalts- und Standkopien für die Filmmontage sowie für die Montagekontrolle verwendet. Die Belichtung und Entwicklung erfolgte wie in Beispiel 1 angegeben.

**Patentansprüche**

1. Lichtempfindliches Gemisch, das als lichtempfindliche Verbindung einen Naphthochinon-(1,2)-diazid-(2)-4- oder -5-sulfonsäureester eines mehrwertigen, Ketogruppen enthaltenden Phenols enthält, dadurch gekennzeichnet, daß der Naphthochinondiazidsulfonsäureester der allgemeinen Formel I

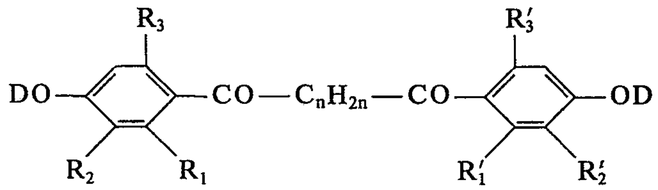

(I)

entspricht, worin

D der Naphthochinon-(1,2)-diazid-(2)-5-sulfonyl- oder -4-sulfonylrest ist,
$R_1$, $R_2$, $R_3$, $R_1'$, $R_2'$ und $R_3'$ Wasserstoff- oder Halogenatome, Alkylgruppen mit 1—4 Kohlenstoffatomen oder Reste der Formel DO sind und
n eine Zahl von 2 bis 18,

bedeutet, wobei insgesamt nicht mehr als drei DO-Reste an einem Benzolring stehen.

2. Lichtempfindliches Gemisch nach Anspruch 1, dadurch gekennzeichnet, daß es zusätzlich ein wasserunlösliches, in wäßrig-alkalischen Lösungen lösliches oder mindestens quellbares Bindemittel enthält.

3. Lichtempfindliches Gemisch nach Anspruch 1, dadurch gekennzeichnet, daß es 3 bis 50 Gew.-% Naphthochinondiazidsulfonsäureester, bezogen auf seinen Gehalt an nicht-flüchtigen Bestandteilen, enthält.

4. Lichtempfindliches Gemisch nach Anspruch 1, dadurch gekennzeichnet, daß es eine Verbindung der Formel I enthält, in der jeweils mindestens einer der Reste $R_1$, $R_2$ und $R_3$ bzw. $R_1'$, $R_2'$ und $R_3'$ ein DO-Rest ist.

5. Lichtempfindliches Gemisch nach Anspruch 4, dadurch gekennzeichnet, daß es eine Verbindung der Formel I enthält, in der $R_1$ und $R_1'$ DO-Reste und $R_2$, $R_3$, $R_2'$ und $R_3'$ Wasserstoffatome sind.

6. Lichtempfindliches Gemisch nach Anspruch 1, dadurch gekennzeichnet, daß es eine Verbindung der Formel I enthält, in der n eine Zahl von 6 bis 14 ist.

7. Lichtempfindliches Kopiermaterial aus einem Schichtträger und einer lichtempfindlichen Schicht, die einen Naphthochinon-(1,2)-diazid-(2)-sulfonsäureester eines mehrwertigen, Ketogruppen enthaltenden Phenols enthält, dadurch gekennzeichnet, daß der Naphthochinondiazidsulfonsäurester der allgemeinen Formel I

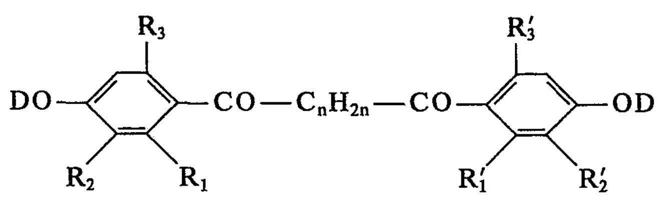

(I)

entspricht, worin

D der Naphthochinon-(1,2)-diazid-(2)-5-sulfonyl- oder -4-sulfonylrest ist,
$R_1$, $R_2$, $R_3$, $R_1'$, $R_2'$ und $R_3'$ Wasserstoff- oder Halogenatome, Alkylgruppen mit 1—4 Kohlenstoffatomen oder Reste der Formel DO sind und

n eine Zahl von 2 bis 18,

bedeutet, wobei insgesamt nicht mehr als drei DO-Reste an einem Benzolring stehen.

8. Lichtempfindliches Kopiermaterial nach Anspruch 7, dadurch gekennzeichnet, daß der Schichtträger aus Aluminium besteht.

## Claims

1. A light-sensitive mixture which contains, as the light-sensitive compound, a 1,2-naphthoquinone-2-diazide-4- or -5-sulfonic acid ester of a polyhydric phenol containing keto groups, characterized in that the naphthoquinone-diazide-sulfonic acid ester corresponds to the general formula I

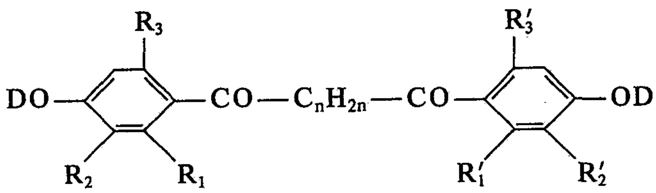

(I)

in which D is a 1,2-naphthoquinone-2-diazide-5-sulfonyl or -4-sulfonyl radical, $R_1$, $R_2$, $R_3$, $R_1'$, $R_2'$ and $R_3'$ are hydrogen atoms or halogen atoms, alkyl groups having 1—4 carbon atoms or radicals of the formula DO and n denotes a number from 2 to 18, no more than three DO radicals in total being present on one benzene ring.

2. A light-sensitive mixture as claimed in claim 1, which additionally contains a binder which is insoluble in water and soluble or at least swellable in aqueousalkaline solutions.

3. A light-sensitive mixture as claimed in claim 1, which contains 3 to 50% by weight of naphthoquinone-diazide-sulfonic acid ester, relative to its content of non-volatile constituents.

4. A light-sensitive mixture as claimed in claim 1, which contains a compound of the formula I in which in each case at least one of the radicals $R_1$, $R_2$ and $R_3$ or $R_1'$, $R_2'$ and $R_3'$ is a DO radical.

5. A light-sensitive mixture as claimed in claim 4, which contains a compound of the formula I in which $R_1$ and $R_1'$ are DO radicals and $R_2$, $R_3$, $R_2'$ and $R_3'$ are hydrogen atoms.

6. A light-sensitive mixture as claimed in claim 1, which contains a compound of the formula I in which n is a number from 6 to 14.

7. A light-sensitive copying material composed of a support and a light-sensitive layer which contains a 1,2-naphthoquinone-2-diazide-sulfonic acid ester of a polyhydric phenol containing keto groups, characterized in that the naphthoquinone-diazide-sulfonic acid ester corresponds to the general formula I

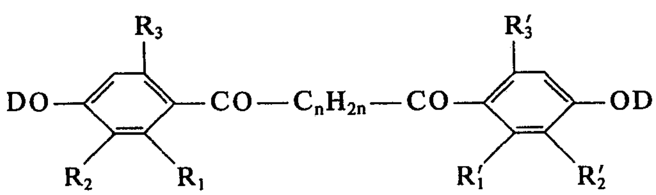

(I)

in which D is a 1,2-naphthoquinone-2-diazide-5-sulfonyl or -4-sulfonyl radical, $R_1$, $R_2$, $R_3$, $R_1'$, $R_2'$ and $R_3'$ are hydrogen atoms or halogen atoms, alkyl groups having 1—4 carbon atoms or radicals of the formula DO and n denotes a number from 2 to 18, no more than three DO radicals in total being present on one benzene ring.

8. A light-sensitive copying material as claimed in claim 7, wherein the support is composed of aluminium.

**Revendications**

1. Mélange photosensible contenant, comme composé photosensible, un ester naphthoquinone(1,2)diazide(2)-4- ou -5-sulfonique d'un polyphénol possédant des groupes cétoniques, caractérisé en ce que l'ester naphthoquinone-diazide-sulfonique correspond à la formule générale I:

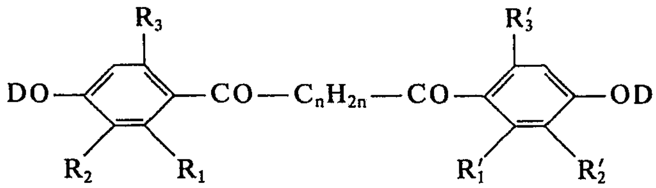

(I)

dans laquelle D est le radical naphthoquinone-(1,2)-diazide-(2)-5-sulfonyle ou -4-sulfonyle, $R_1$, $R_2$, $R_3$, $R_1'$, $R_2'$ et $R_3'$ sont des atomes d'hydrogène ou d'halogène, des groupes alkyle ayant 1 à 4 atomes de carbone ou des radicaux de formule DO et n désigne un nombre de 2 à 18, un cycle benzénique ne pouvant porter plus de trois radicaux DO au total.

2. Mélange photosensible selon la revendication 1, caractérisé en ce qu'il contient en outre un liant insoluble dans l'eau et soluble ou au moins susceptible de gonfler dans les solutions alcalines aqueuses.

3. Mélange photosensible selon la revendication 1, caractérisé en ce qu'il contient 3 à 50% en poids d'ester naphthoquinone-diazide-sulfonique par rapport à sa teneur en constituants non volatils.

4. Mélange photosensible selon la revendication 1, caractérisé en ce qu'il contient un composé de formule I dans laquelle, dans chaque cas, au moins un des radicaux $R_1$, $R_2$ et $R_3$ ou $R_1'$, $R_2'$ et $R_3'$ est un radical DO.

5. Mélange photosensible selon la revendication 4, caractérisé en ce qu'il contient un composé de formule I dans laquelle $R_1$ et $R_1'$ sont des radicaux DO et $R_2$, $R_3$, $R_2'$ et $R_3'$ sont des atomes d'hydrogène.

6. Mélange photosensible selon la revendication 1, caractérisé en ce qu'il contient un composé de formule I dans laquelle n est un nombre de 6 à 14.

7. Matériau photosensible pour copie, constitué d'un support et d'une couche photosensible contenant un ester naphtoquinone-(1,2)-diazide(2)sulfonique d'un polyphénol possédant des groupes cétoniques, caractérisé en ce que l'ester naphthoquinone-diazide-sulfonique correspond à la formule générale I:

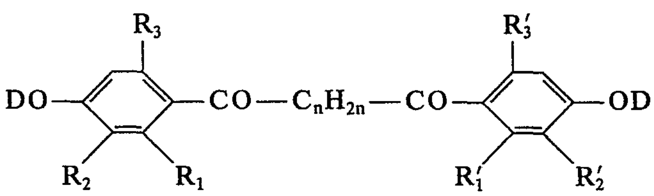

(I)

dans laquelle D est le radical naphthoquinone-(1,2)-diazide-(2)-5-sulfonyle ou -4-sulfonyl, $R_1$, $R_2$, $R_3$, $R_1'$, $R_2'$ et $R_3'$ sont des atomes d'hydrogène ou d'halogène, des groupes alkyle ayant 1 à 4 atomes de carbone ou des radicaux DO et n est un nombre de 2 à 18, un cycle benzénique ne pouvant porter plus de trois radicaux DO au total.

8. Matériau photosensible pour copie selon la revendication 7, caractérisé en ce que le support est en aluminium.